Europäisches Patentamt

European Patent Office

Office européen des brevets

(19)

(11) Numéro de publication: **0 376 777**
**A1**

(12) **DEMANDE DE BREVET EUROPEEN**

(21) Numéro de dépôt: 89403364.6

(22) Date de dépôt: 05.12.89

(51) Int. Cl.⁵: **H01L 21/82, H01L 29/60, H01L 29/796**

(30) Priorité: 30.12.88 FR 8817483

(43) Date de publication de la demande: 04.07.90 Bulletin 90/27

(84) Etats contractants désignés: DE FR GB NL

(71) Demandeur: **THOMSON COMPOSANTS MILITAIRES ET SPATIAUX**
**50, rue J.P. Timbaud**
**F-92400 Courbevoie(FR)**

(72) Inventeur: **Blanchard, Pierre**
**THOMSON-CSF SCPI Cédex 67**
**F-92045 Paris la Défense(FR)**

(74) Mandataire: **Guérin, Michel et al**
**THOMSON-CSF SCPI**
**F-92045 PARIS LA DEFENSE CEDEX 67(FR)**

(54) **Procédé de fabrication d'un dispositif à transfert de charges.**

(57) L'invention concerne un procédé de fabrication d'un dispositif à transfert de charges.

Les électrodes (53) du registre sont formées à partir de plusieurs niveaux de silicium polycristallin. Au lieu que le premier niveau corresponde à une première électrode, le deuxième à une électrode voisine, et le troisième à encore une autre électrode, on prévoit dans cette invention que toutes les électrodes (53) d'un même pas du registre sont réalisées simultanément et identiquement à partir de ces différents niveaux de silicium polycristallin. Une implantation ionique (50) a lieu entre deux dépôts dans le cas de registres à électrodes mixtes (stockage/transfert). Cela permet notamment d'avoir des électrodes très identiques dans ce dernier cas. Selon une caractéristique importante de l'invention, tous les niveaux de silicium polycristallin sont reliés électriquement les uns aux autres à l'intérieur d'une même électrode, ce qui n'était pas le cas auparavant. On aboutit à un registre dont toutes les électrodes sont identiques, même dans le cas où une implantation (50) est nécessaire sous l'extrémité des électrodes.

FIG. 15 a

## PROCEDE DE FABRICATION D'UN DISPOSITIF A TRANSFERT DE CHARGES

La présente invention concerne un procédé de fabrication d'un dispositif à transfert de charges.

Elle s'applique notamment aux systèmes vidéo dans lesquels les charges résultant de l'absorption de photons sont collectées dans des puits de potentiel.

On sait que les dispositifs à transfert de charges utilisent généralement des signaux de commande à deux ou quatre phases pour effectuer un transfert dee charges d'un puits de potentiel à un autre. Ces signaux sont appliqués à des électrodes formées sur un substrat semi-conducteur de silicium dopé d'un premier type, recouvert par une couche semi-conductrice de silicium dopé d'un deuxième type, elle-même recouverte d'une couche isolante d'oxyde de silicium.

Tout dispositif à transfert de charges comporte donc des groupes successifs et identiques d'électrodes.

Ces dispositifs sont dits à deux ou quatre phases selon qu'il est nécessaire d'appliquer aux électrodes d'un groupe, des signaux présentant deux ou quatre phases différentes, pour que les charges stockées dans un puits de potentiel correspondant au groupe d'électrodes considéré passent dans un puits de potentiel correspondant à un groupe d'électrodes adjacent au groupe considéré.

Les dispositifs à transfert de charges peuvent aussi être classés selon le nombre de niveaux de silicium polycristallin utilisés dans leur fabrication. Si au cours de la fabrication du dispositif deux couches de silicium polycrystallin sont nécessaires pour constituer les électrodes, le dispositif à transfert de charges est qualifié de dispositif à transfert de charges à deux niveaux d'électrodes. Si trois couches sont nécessaires pour constituer les électrodes, le dispositif est alors qualifié de dispositif à trois niveaux d'électrodes. Les électrodes du premier niveau correspondent généralement à la fonction de stockage des charges, tandis que les électrodes de deuxième niveau et éventuellement de troisième niveau, correspondent à la fonction de transfert des charges d'un puits de potentiel à un autre.

Un autre paramètre essentiel permettant de définir un dispositif à transfert de charges est le pas élémentaire. Ce pas correspond à la largeur de chaque groupe d'électrodes qui comporte généralement quatre électrodes, permettant d'assurer le fonction de stockage de charges dans un puits de potentiel et la fonction de transfert de ces charges vers le puits de potentiel d'un groupe d'électrodes voisin.

Un moyen de réduire le pas d'un dispositif à transfert de charges, est l'utilisation de paires d'électrodes successives. Les électrodes de chaque paire assurent le double fonction de stockage et de transfert des charges. Ces électrodes sont dites mixtes. Un dispositif à transfert de charges comprenant des électrodes mixtes est décrit notamment dans la demande de brevet européen N° 0207328.

La réduction du pas d'un dispositif à transfert de charges est liée aux performances de photolithogravure qui permettent de déterminer avec précision les emplacements de zones implantées de troisième type dans la couche semi-conductrice de deuxième type recouvrant le substrat semi-conducteur de premier type. La demande de brevet précitée décrit en particulier un dispositif à transfert de charges présentant un pas réduit, grâce à l'utilisation de deux niveaux d'électrodes mixtes et grâce à des opérations de photolithogravure permettant de définir avec une assez grande précision, les dimensions des zones implantées de troisième type. Par "type de conductivité" on entend ici la combinaison de natures d'impuretés de dopage et d'une densité de ces impuretés.

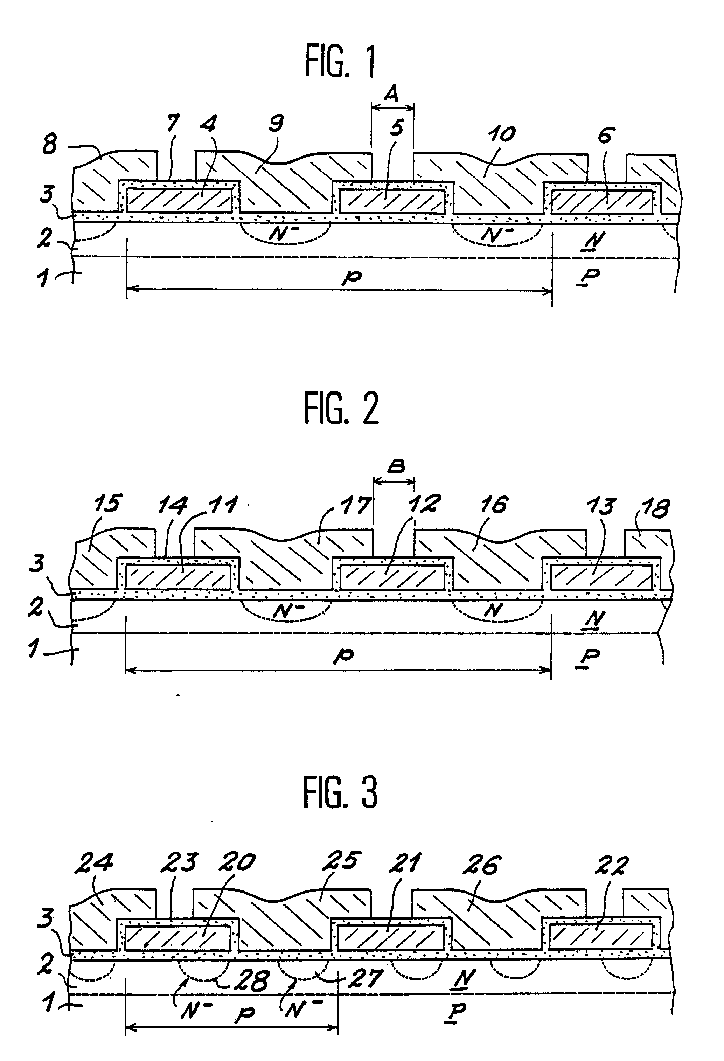

Les figures 1, 2 et 3 permettent de mieux comprendre les divers types de dispositifs à transfert de charges, connus dans l'état de la technique.

La figure 1 représente schématiquement et en coupe un dispositif à transfert de charges à deux niveaux d'électrodes. Ce dispositif comporte un substrat semi-conducteur 1 de silicium dopé d'un premier type (de type P par exemple) sur lequel est réalisée une couche 2 semi-conductrice de silicium dopé d'un deuxième type (type N par exemple), elle-même recouverte par une couche isolante 3 d'oxyde de silicium. Des électrodes telles que 4, 5, 6 sont réalisées dans une première couche de silicium polycristallin, déposée sur la couche isolante 3. Ces électrodes sont dites de premier niveau. Elles sont recouvertes d'une couche isolante 7 d'oxyde de silicium. D'autres électrodes telles que 8, 9, 10, dites de deuxième niveau, sont réalisées dans une deuxième couche de silicium polycristallin, déposée sur les électrodes de premier niveau et entre ces électrodes du premier niveau. Préalablement au dépôt de la deuxième couche de silicium polycristallin permettant de réaliser les électrodes de deuxième niveau, des zones semi-conductrices d'un troisième type (N- par exemple) sont implantées dans la couche semiconductrice 2 de deuxième type. Ce dispositif peut être à deux ou à quatre phases de signaux de commande. Le dispositif est à deux phases si on applique le même signal de commande à deux électrodes successives telles que 4, 9 de deux niveaux différents. Il est à quatre phases si on applique quatre signaux de commande de phases différentes respectivement à quatre électrodes successives telles que 4, 9, 5, 10 pour faire passer les charges stockées dans un puits de potentiel situé dans la couche semi-conductrice 1 de premier type, en regard de l'électrode 4, à un puits de potentiel situé dans cette couche en regard de l'électrode 6. Dans le cas d'un transfert à quatre phases, l'implantation $N^-$ n'est pas nécessaire. Le pas p d'un dispositif de ce type, à deux niveaux d'électrodes et à deux ou quatre phases correspond donc à l'encombrement de quatre électrodes.

La figure 2 représente schématiquement et en coupe, un autre dispositif à transfert de charges connu dans l'état de la technique. Ce dispositif comporte, comme le précédent, un substrat semi-conducteur 1 de silicium dopé d'un premier type (type P par exemple), surmonté d'une couche semi-conductrice 2 de silicium dopé d'un deuxième type (type N par exemple), elle-même recouverte par une couche isolante 3 d'oxyde de silicium. Sur cette couche d'oxyde sont formées des électrodes telles que 11, 12, 13 d'un premier niveau, découpées dans une première couche de silicium polycristallin. Des zones semi-conductrices d'un troisième type (type $N^-$ par exemple) sont alors implantées entre ces électrodes, dans la couche semi-conductrice 2 de deuxième type. Les électrodes de premier niveau sont recouvertes d'une couche isolante 14 d'oxyde de silicium. Ensuite, des électrodes telles que 15, 16, de deuxième niveau, sont réalisées par gravure d'une deuxième couche de silicium polycristallin, déposée sur les électrodes de premier niveau. Enfin, des électrodes telles que 17, 18, de troisième niveau sont réalisées dans une troisième couche de silicium polycristallin déposée sur les électrodes de premier niveau et entre ces électrodes.

Ce type de dispositif peut être à deux ou quatre phases et son pas p correspond à un encombrement de quatre électrodes telles que 11, 17, 12, 16. En effet, des charges stockées dans un puits de potentiel situé dans la couche semi-conductrice 2 de deuxième type, en regard de l'électrode 11 de premier niveau, peuvent être amenées dans un puits de potentiel situé en regard de l'électrodes 13 de premier niveau, en appliquant aux électrodes 11, 17, 12, 16 des potentiels présentant deux ou quatre phases différentes.

Le pas des dispositifs des figures 1 et 2 correspond donc à quatre électrodes et leur encombrement est donc important.

L'intérêt d'un procédé à trois niveaux d'électrodes de la figure 2 est de réduire le pas : en effet, l'intervalle B entre deux électrodes supérieures est défini par deux photogravures, ce qui n'est pas le cas de la figure 1 où "A" est défini par une seule photogravure et est donc limité par les performances de cette seule photogravure.

Une manière de réduire le pas d'un dispositif à transfert de charges est de réaliser des électrodes dites mixtes à deux phases de signaux de commande, permettant d'assurer en même temps le fonction de stockage de charges dans un puits de potentiel et la fonction de transfert de ces charges vers un puits de potentiel adjacent.

La figure 3 représente schématiquement et en coupe transversale un dispositif à transfert de charges, connu dans l'état de la technique, à électrodes mixtes et à deux phases de signaux de commande. Un dispositif à transfert de charges de ce type est décrit est décrit dans la demande de brevet européen N° 0207328. Ce dispositif comporte comme les précédents, un substrat semi-conducteur 1 de silicium dopé d'un premier type (type P par exemple) surmonté d'une couche semconductrice 2 de silicium dopé d'un deuxième type (type N par exemple), elle-même recouverte par une couche isolante d'oxyde de silicium 3. Le dispositif comporte des électrodes de premier niveau telles que 20, 21, 22, réalisées dans une première couche de silicium polycristallin et recouvertes par une couche isolante d'oxyde de silicium 23. Ce dispositif comporte aussi des électrodes telles que 24, 25, 26 de deuxième niveau, réalisées dans une deuxième couche de silicium polycristtalin. Enfin, il comporte des zones semi-conductrices de silicium dopé de troisième type ($N^-$ par exemple) ; ces zones sont implantées dans la couche semi-conductrice 2 de deuxième type, en regard de portions de surface d'électrodes du premier niveau et d'électrodes du deuxième niveau. La délimitation des zones semi-conductrices 27 de troisième type en regard de portions de surface des électrodes 25 de deuxième niveau, peut être définie avant le dépôt de la deuxième couche de silicium polycristallin sur les électrodes 20 de premier niveau. En effet, avant ce dépôt, les électrodes 20 de premier niveau étant déjà réalisées, pour délimiter les zones semi-conductrices 27 de troisième type (implantées ioniquement par exemple), il suffit, comme indiqué dans la demande de brevet précitée, de réaliser entre les électrodes 20 et 21 de premier niveau, le long de l'électrode 20, un remblai isolant, d'oxyde de silicium par exemple, délimitant la zone à implanter entre le bord de de remblai et le bord de l'électrode 21. La délimitation des zones implantées 28 de troisième type, en regard de portions de surface d'électrodes 20 de premier niveau est plus délicate et nécessite de nombreuses opérations de masquage, telles que décrites dans le demande de brevet précitée.

Ce type de dispositif a cependant pour avantage de fonctionner avec deux phases de signaux de commande et de présenter un pas P qui est réduit à l'encombrement de deux électrodes. En effet, comme indiqué dans la demande de brevet précitée, il suffit de deux électrodes respectivement d'un premier niveau et d'un deuxième niveau, pour faire passer des charges stockées dans un puits de potentiel situé en regard d'une électrode de premier niveau, à un puits de potentiel situé en regard d'une électrode suivante de premier niveau. Malgré cet avantage, ce type de dispositif a pour inconvénient supplémentaire de présenter des électrodes de dimensions différentes.

Un but de l'invention est de proposer un nouveau procédé de fabrication qui permette de réaliser des registres à décalage à transferts de charge de pas réduit, par des opérations plus simples et moins coûteuses que dans l'art antérieur. Le procédé s'applique notamment , mais non exclusivement à des registres à électrodes mixtes servant à la fois au stockage et au transfert.

L'idée originale de l'invention est que pour obtenir ce pas réduit et cette simplification de procédé dans un grand nombre de cas, et surtout dans le cas des registres à électrodes mixtes, il faut s'écarter du préjugé habituel selon lequel les différentes électrodes correspondant à un pas du registre doivent être réalisées par des étapes de procédé distinctes. Autrement dit, dans l'art antérieur, on a toujours considéré que s'il y a au moins deux électrodes dans un pas du registre, il faut réaliser la première électrode par certaines étapes de procédé, et d'autres électrodes par d'autres étapes.

Une caractéristique importante de l'invention est le fait que, pour la réalisation d'un registre à décalage à transfert de charges comprenant des électrodes au dessus d'une couche semiconductrice dopée, on réalise toutes les électrodes correspondant à un pas du registre par des étapes de procédé identiques et simultanées pour toutes les électrodes.

Autrement dit, même si le pas du registre ne comprend que deux électrodes, on réalise ces deux électrodes rigoureusement simultanément et identiquement (et non pas par des étapes différentes, par exemple par des dépôts conducteurs successifs différents pour les différentes électrodes comme on le fait toujours).

Une autre aspect important de l'invention est le fait que les électrodes sont toutes réalisées par plusieurs dépôts conducteurs tous reliés électriquement les uns aux autres pour une même électrode après la fin du procédé (alors que dans l'art antérieur, les dépôts successifs correspondent normalement à des électrodes différentes et ils ne sont donc pas reliés les uns aux autres).

En particulier, une manière de procéder pourra être la suivante : sur un substrat comprenant une couche semiconductrice recouverte d'une couche isolante, on dépose une première couche conductrice et on la grave pour définir des bandes séparéss; on forme un isolant superficiel au moins sur un flanc latéral de ces bandes; on dépose une deuxième couche conductrice venant en contact avec une partie dénudée de chaque bande; on grave la deuxième couche de part et d'autre du flanc recouvert d'isolant en formant un espace vide étroit entre deux bandes adjacentes, le flanc isolant établissant alors une isolation électrique entre bandes adjacentss; on dépose une troisième couche conductrice fortement couvrante qui remplit l'espace étroit; et on grave la troisième couche sur une profondeur suffisante pour mettre à nu une portion de bande recouverte d'isolant et ainsi séparer électriquement une portion de troisième couche au dessus d'une bande et une portion de troisième couche au dessus d'une bande adjacente. Dans cette dernière gravure, il n'est même pas nécessaire en principe d'utiliser un masque de gravure. Comme on le voit, les trois dépôts conducteurs successifs réalisent simultanément et identiquement les électrodes adjacentes correspondant à un même pas, qu'il y ait deux ou trois ou quatre électrodes dans un pas. Et on voit aussi que les trois dépôts conducteurs sont reliés électriquement les uns aux autres dans chaque électrode, y compris après la fin du procédé.

Dans l'application à des registres mixtes, l'invention est tout particulièrement intéressante, car il suffit de réaliser par exemple un dopage au dessous des électrodes, entre un dépôt conducteur et un autre dépôt conducteur ultérieur.

Dans l'exemple détaillé expliqué ci-dessus avec trois couches conductrices électriquement reliées les unes aux autres un dopage (de préférence par implantation ionique) sera fait dans l'intervalle étroit gravé après dépôt de la deuxième couche, intervalle qui sera rebouché par la troisième couche.

Dans le cas des registres à électrodes mixtes, l'invention propose de réaliser les électrodes d'un même pas de registre toutes identiques les unes aux autres, avec des zones de dopage local particulier au dessous d'un bord de chacune de ces électrodes. Cela est particulièrement avantageux dans le cas des électrodes mixtes puisque les électrodes remplissent toutes le même rôle.

L'invention sera décrite plus en détail à titre d'exemple à propos d'un dispositif à transfert de charges à électrodes mixtes et à pas réduit. Dans ce cas elle a pour but de remédier aux inconvénients de fabrication de ce type de dispositif et permet notamment de réduire sensiblement le nombre d'opérations nécessaires à la délimitation des zones semi-conductrices de troisième type, réalisées dans la couche semi-conductrice de deuxième type.

On verra comment ces buts sont atteints grâce à un procédé de réalisation dans lequel les électrodes mixtes sont réalisées dans trois couches différentes de silicium polycristallin. Le premier niveau de silicium polycristallin définit une partie de la zone de stockage des charges dans des puits de potentiel. Le deuxième niveau définit à la fois le complément de cette zone de stockage et la zone de transfert. Le troisième niveau sert dans un dispositif obtenu selon un premier mode de mise en oeuvre du procédé, de complément à l'électrode pour assurer le recouvrement de celle-ci au-dessus de la zone de transfert. Ce procédé permet aussi de définir des électrodes de mêmes dimensions, ce qui n'est pas du tout le cas du dispositif connu par la demande de brevet EP 0207328.

En effet, dans cette demande de brevet, le procédé utilisé nécessite deux implantations différentes pour deux électrodes successives. Ces implantations différentes exigent quatre niveaux de masquage et donc des positionnements très délicates des masques utilisés. Ces niveaux de masquage définissant les largeurs actives des électrodes, un défaut de positionnement de l'un des masques entraîne des défauts de positionnement des zones implantées de troisième type.

La solution proposée dans le procédé de l'invention résout ce problème de positionnement, notamment grâce à l'utilisation d'un seul niveau de masquage à positionnement délicat. Le dispositif obtenu grâce au procédé de l'invention présente de plus des zones de transfert de charges de dimensions plus faibles que les zones de stockage, et permet ainsi d'accroître la quantité de charges stockées.

Dans une réalisation particulière, l'invention a pour objet un procédé de fabrication d'un dispositif à transfert de charges consistant à utiliser un substrat semi-conducteur de silicium dopé d'un premier type recouvert par une couche semi-conductrice de silicium dopé d'un deuxième type, elle-même recouverte d'une première couche isolante principale, caractérisé en ce qu'il consiste ensuite :
- à former une première couche de silicium polycristallin sur la première couche isolante principale, puis à découper des bandes à flancs parallèles dans cette première couche de silicium polycristallin, en mettant à nu la couche semi-conductrice de deuxième type, entre ces bandes,
- à former au moins une deuxième couche isolante principale entre lesdites bandes, à la surface de chaque bande et sur au moins l'un des flancs de chaque bande, puis à déposer une deuxième couche de silicium polycristallin sur la deuxième couche isolante principale,
- à découper la deuxième couche de silicium polycristallin, par gravure à travers un masque, pour laisser subsister au moins un remblai de la deuxième couche de silicium polycristallin sur le flanc de chaque bande recouvert de la deuxième couche isolante principale, et pour creuser au moins une rainure mettant à nu la deuxième couche isolante principale le long de chaque remblai de la deuxième couche de silicium polycristallin et pour mettre à nu la deuxième couche isolante principale au moins partiellement à la surface de chaque bande,
- à effectuer une implantation ionique pour former des zones semi-conductrices dopées de troisième type dans la couche semi-conductrice dopée de deuxième type, respectivement en regard d'un ensemble de rainures,
- à former une troisième couche de silicium polycristallin sur les parties subsistantes de la deuxième couche de silicium polycristallin et sur les parties mises à nu de la deuxième couche isolante principale, puis à effectuer une planarisation et une gravure de la troisième couche de silicium polycristallin pour ne laisser subsister cette troisième couche de silicium polycristallin que dans lesdites rainures.

Selon un mode de mise en oeuvre de ce procédé, le découpage des bandes parallèles dans la première couche de silicium polycristallin, en mettant à nu la couche semi-conductrice de deuxième type entre ces bandes, consiste : - à découper lesdites bandes parallèles par gravure sélective à travers un masque, de la première couche de silicium polycristallin,
- à former sur ces bandes et sur la première couche isolante principale entre ces bandes, une première couche isolante intermédiaire de nitrure de silicium recouverte par une deuxième couche isolante intermédiaire d'oxyde de silicium,
- à effectuer une gravure anisotrope de la deuxième couche isolante intermédiaire pour laisser subsister des remblais de la deuxième couche isolante intermédiaire, le long des flancs de chaque bande,
- à effectuer une attaque chimique à travers un masque, d'un remblai de chaque bande, les remblais subsistants à la suite de cette attaque étant situés d'un même côté de chaque bande,
- à effectuer une gravure de la deuxième couche isolante intermédiaire et des remblais subsistants pour ne laisser subsister que des zones de cette deuxième couche intermédiaire, en regard des emplacements desdits remblais,
- à effectuer une attaque chimique de la première couche principale d'isolant, non protégée par chaque bande et non protégée par les zones subsistantes de la premier couche isolante intermédiaire.

Dans le cas où on veut faire coexister sur un même substrat des registres selon l'invention et des registres à quatre phases classiques, on notera que les étapes de procédé sont compatibles pour les deux types de registres; dans ce cas, pour les registres classiques à quatre phases, le découpage des bandes parallèles dans la première couche de silicium polycristallin, en mettant à nu la couche semi-conductrice de deuxième type entre ces bandes consiste :

- à découper lesdites bandes parallèles par gravure sélective à travers un masque, de la première couche de silicium polycristallin,
- à former sur ces bandes et sur la première couche isolante principale, entre ces bandes, une première couche isolante intermédiaire de nitrure de silicium, recouverte par une deuxième couche isolante intermédiaire d'oxyde de silicium,
- à effectuer une gravure anisotrope de la deuxième couche isolante intermédiaire, pour laisser subsister des remblais de la deuxième couche isolante intermédiaire, le long des flancs de chaque bande,
- à effectuer une attaque chimique des remblais et une gravure de la première couche isolante intermédiaire,
- à effectuer une attaque chimique de la première couche principale d'isolant non protégée pour chaque bande.

Les caractéristiques et avantages du procédé de l'invention ressortiront mieux de la description qui va suivre donné en référence aux dessins annexés dans lesquels :

     - les figures 1 à 3, déjà décrites, représentent schématiquement des dispositifs à transfert de charges, connus dans l'état de la technique,

     - les figures 4A à 15A représentent schématiquement les étapes successives du procédé de fabrication du dispositif de l'invention, pour un mode de mise en oeuvre très détaillé de ce procédé, donné simplement à titre d'exemple non limitatif,

     - les figures 4B à 15B représentent schématiquement les étapes successives du procédé, montrant comment il reste compatible avec la réalisation d'un registre classique réalisé sur le même substrat.

On notera en préambule que la description qui suit est faite de manière à montrer comment le procédé de réalisation selon l'invention, appliqué à un registre à électrodes mixtes, est compatible avec réalisation simultanée sur le même substrat semiconducteur d'un registre plus classique à quatre phases. Mais le registre plus classique n'est pas réalisé avec les caractéristiques les plus importantes selon l'invention : les étapes de procédé ne sont pas identiques et simultanées pour toutes les électrodes correspondant à un même pas de registre.

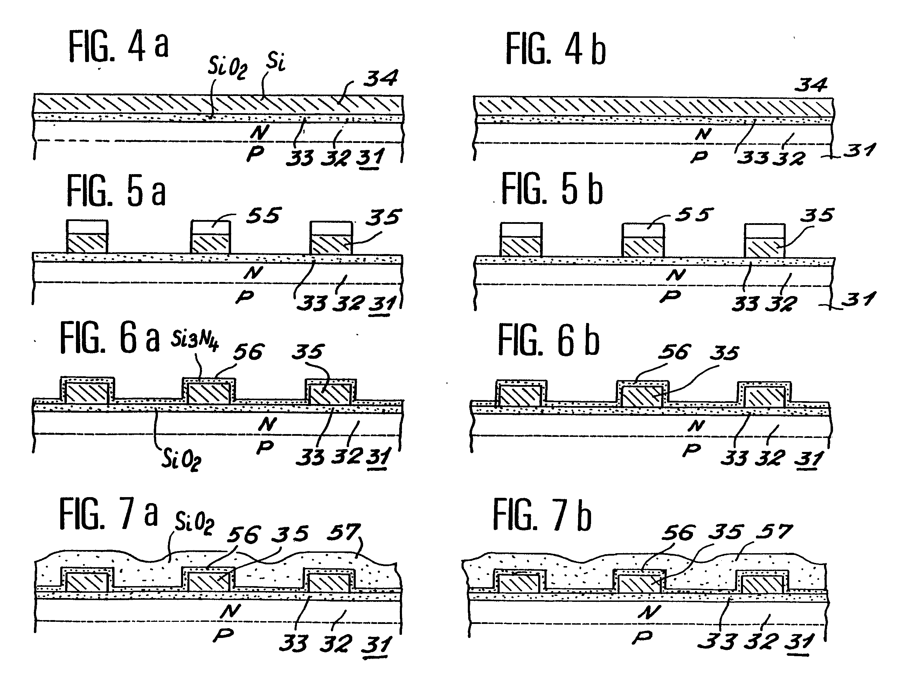

Ce procédé consiste tout d'abord comme représenté sur les figures 4A et 4B à utiliser un substrat semi-conducteur 31 de silicium dopé de premier type (P par exemple), recouvert par une couche semi-conductrice 32 dopée d'un deuxième type (de type N par exemple), elle-même recouverte d'une première couche isolante principale 33 d'oxyde de silicium par exemple.

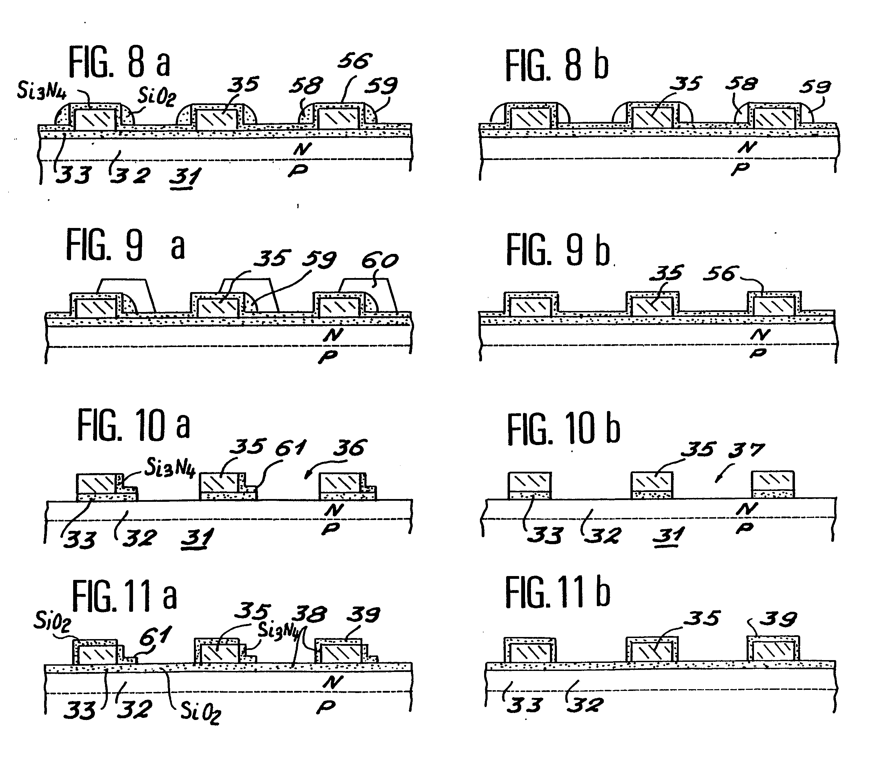

Le procédé consiste ensuite à former une première couche de silicium polycristallin 34 sur la première couche isolante principale 33. Des bandes 35 à flancs parallèles, telles que représentées sur les figures 5A et 5B, sont ensuite découpées dans la première couche de silicium polycristallin 34 en mettant à nu la couche semi-conductrice 32 du deuxième type, dans des zones 36 (figure 10A) ou 37 (figure 10B), entre ces bandes 35.

Les différentes étapes du procédé de l'invention qui permettent de mettre à nu des zones 36 ou 37 de la surface de la couche semi-conductrice de deuxième type, sont représentées schématiquement sur les figures 5A à 9A pour un registre à électrodes mixtes selon l'invention et sur les figures 5B à 9B pour un registre classique réalisé simultanément; ces étapes seront décrites plus loin en détail.

Le procédé consiste alors à former au moins une deuxième couche isolante principale 38 (figure 11A) ou 39 (figure 11B) entre lesdites bandes, de manière à recouvrir de préférence les zones 36 ou 37 de la surface mise à nu de la deuxième couche semi-conductrice 32. Cette couche isolante est aussi formée de préférence à la surface de chaque bande 35 et surtout sur au moins l'un des flancs de chaque bande.

On enlève le reste de nitrure 61 situé sur un flanc de chaque bande 35, ce qui dénude ce flanc.

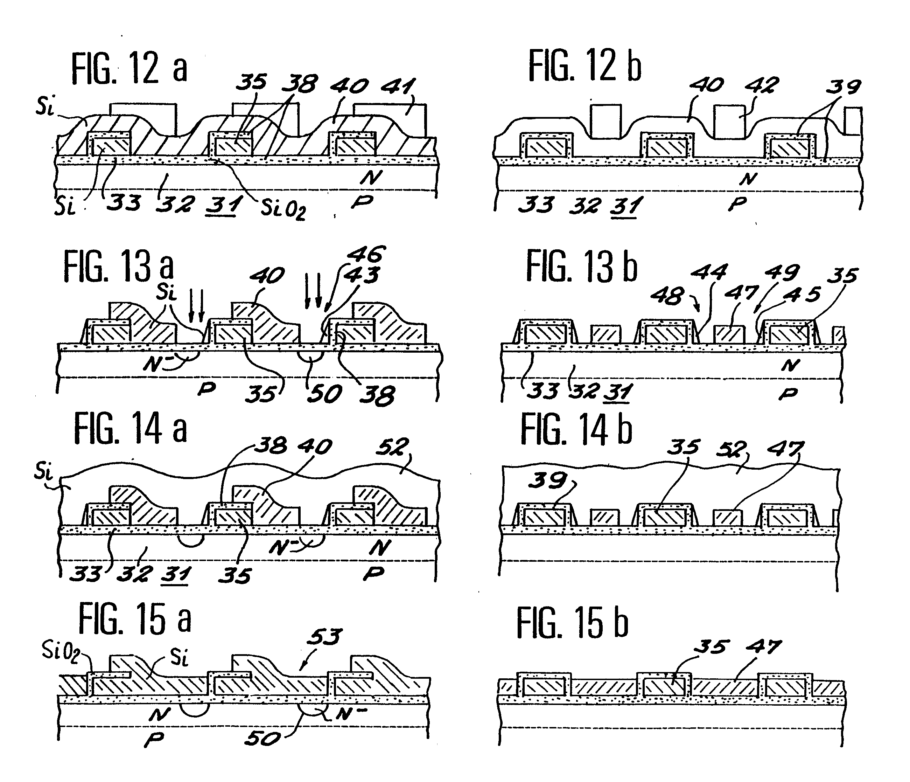

Comme représenté sur les figures 12A et 12B, le procédé consiste ensuite à déposer une deuxième couche de silicium polycristallin 40 sur la deuxième couche isolante 38. Cette deuxième couche de silicium plycristallin recouvre bien entendu, dans le registre mixte et tel que représenté sur la figure 12A, le flanc de chaque bande 35 non recouvert par la deuxième couche isolante principale 38.

Le procédé consiste alors à découper la deuxième couche de silicium polycristallin 40 par gravure à travers un masque 41 (figure 12A) ou 42 (figure 12B). On grave le silicium de part et d'autre du flanc recouvert d'isolant des bandes 35.

Cette gravure laisse subsister en pratique au moins un remblai de la deuxième couche 40 de silicium polycristallin le long du flanc isolé.

C'est ainsi que la gravure à travers le masque 41 laisse subsister un remblai 43 (figure 13A) sur le flanc de la bande 35 qui est recouvert par la deuxième couche isolante principale 38.

De la même manière, comme représenté sur la figure 13B, la gravure à travers le masque 42 laisse subsister deux remblais 45, 45 de la deuxième couche de silicium polycristallin, sur le flanc de chaque bande 35 recouvert de la deuxième couche isolante principale 39. Dans les deux cas, la gravure à travers un masque, tel que représenté sur les figures 12A ou 12B, est de préférence de type anisotrope.

La gravure à travers le masque 41 laisse aussi subsister (tel que représenté sur la figure 13A) des portions de la deuxième couche de silicium polycristallin ; ces portions recouvrent partiellement la deuxième couche isolante principale 38 entre les bandes 35, ainsi qu'une partie de cette couche isolante, à la surface des bandes 35. Cette gravure permet également de creuser des rainures étroites telles que 46 qui mettent à nu la deuxième couche isolante 38 le long de chaque remblai 43 de la deuxième couche 43 de silicium polycristallin.

Dans le cas de la figure 13B, la gravure à travers le masque 42 permet de laisser subsister, outre les remblais 44, 45 de la deuxième couche de silicium polycristallin 40, des bandes 47 de cette deuxième couche de silicium polycristallin, entre chacune des bandes 35 de la première couche de silicium polycristallin. Cette gravure permet également de mettre à nu la deuxième couche isolante principale 39, à la surface de chaque bande 35 de la première couche de silicium polycristallin, ainsi qu'en regard de rainures 48, 49, creusées par cette gravure le long des remblais 44, 45. Il en résulte que le flanc isolant (et éventuellement aussi la couche isolante 38 au dessus des bandes) établit une isolation électrique entre bandes adjacentes.

Le procédé consiste ensuite, dans le cas d'un registre à électrodes mixtes qui nécessite généralement un dopage localisé au dessous d'un bord de chaque électrode, à effectuer une implantation ionique (ou un dopage d'une autre manière) pour former des zones semi-conductrices dopées d'un troisième type (de type N⁻ par exemple) dans la couche semi-conductrice 32 dopée de deuxième type, en regard d'un ensemble de rainures. Ces zones dopées de troisième type sont représentées en 51 sur la figure 13A. Pour le registre classique de la figure 13B, l'utilisation d'un masque est nécessaire pour ne pas effectuer d'implantation en regard de chaque rainure.

Enfin, le procédé consiste à former une troisième couche de silicium polycristallin 52 sur les parties subsistantes de la deuxième couche 40 ainsi que sur les parties mises à nu de la deuxième couche isolante principale 38 (figure 14A) ou 39 (figure 14B). Les rainures sont ainsi comblées par cette troisième couche 52 de silicium polycristallin.

Cette couche 52 est gravée sans masque, en mode isotrope, de manière à obtenir les structures représentées sur les figures 15A et 15B. La gravure est suffisamment profonde pour mettre à nu une portion de couche isolante sur le flanc ou sur le dessus des bandes de silicium polycristallin, pour séparer électriquement les portions de troisième couche au dessus d'une bande d'avec les portions de troisième couche au dessus d'une bande adjacente. Au cours de cette gravure, le silicium polycristallin déposé dans les rainures 46 subsiste, de sorte que l'électrode finale réalisée s'étend sur toute la surface comprise entre un flanc latéral isolé d'une bande et le flanc latéral isolé de la bande adjacente.

Les électrodes 53 obtenues dans le registre à décalage à électrodes mixtes de l'invention sont identiques et les zones implantées de troisième type 50 sont bien délimitées grâce au procédé utilisé. Le dispositif obtenu est à deux phases, à deux niveaux d'électrodes identiques, et à pas réduit.

Le dispositif représenté schématiquement sur la figure 15B, est un dispositif à quatre phases. Les électrodes sont identiques deux à deux. En effet, en quatre phases l'implantation N⁻ n'est pas nécessaire, mais l'enchaînement des opérations communes aux dispositifs à deux et quatre phases réalisées sur le même substrat, nécessite l'utilisation d'un masque à l'étape de la figure 13b.

Seules subsistent pratiquement après la gravure de la troisième couche 52 de silicium polycristallin, les parties de cette couche qui remplissent les rainures 46 (de la figure 13A) ou les rainures 48, 49 (de la figure 13B).

On va maintenant décrire les étapes initiales du procédé ; celles-ci permettent de réaliser le découpage des bandes parallèles 35 de la première couche de silicium polycristallin 34, en mettant à nu la couche semi-conductrice 32 de deuxième type, tel que représenté sur la figure 10A ou sur la figure 10B. Les étapes illustrées par les figures 5A à 8A et 5B à 8B, dans les deux cas, sont identiques. Elles diffèrent ensuite pour permettre d'obtenir pour un registre selon l'invention des bandes conductrices de silicium polycristallin du premier niveau ayant un flanc dénudé permettant ensuite un contact électrique avec le silicium polycristallin du deuxième niveau. Ce flanc dénudé n'est pas prévu dans le registre à décalage à quatre phases formé simultanément.

Les bandes parallèles 35 sont découpées par gravure sélective à travers un masque 55 de la première couche 35 de silicium polycristallin, tel que représenté schématiquement sur les figures 5A et 5B.

Ensuite, après élimination du masque 55 et comme représenté sur les figures 6A et 6B, on forme sur les bandes 35 de la première couche 34 de silicium polycristallin, ainsi qu'entre ces bandes, sur la première couche isolante principale 33 d'oxyde de silicium, une première couche isolante intermédiaire 56 de nitrure de silicium : celui-ci est alors recouvert, comme représenté sur les figures 7A et 7B, par une deuxième couche isolante intermédiaire 57 d'oxyde de silicium.

On effectue ensuite une gravure anisotrope de la deuxième couche isolante intermédiaire 57 d'oxyde de silicium, de manière à laisser subsister des remblais tels que 58, 59 (figures 8A et 8B) de la deuxième couche isolante intermédiaire 57, le long des flancs de chaque bande ; ces remblais sont séparés de ces flancs par la deuxième couche isolante intermédiaire 56 de nitrure de silicium.

On protège alors par un masque 60 le remblai 59 du côté ou la bande devra être dénudée finalement, et on élimine tous les autres remblais, y compris ceux du registre 4 phases réalisé simultanément.

On effectue alors (figure 10A), une gravure de la deuxième couche isolante intermédiaire 56 pour ne laisser subsister que des zones 61 de cette deuxième couche intermédiaire de nitrure de silicium, qui sont protégées par les remblais 59.

Enfin, tel que représenté sur la figure 10A, on effectue une attaque chimique de la première couche isolante principale 33, non protégée par chaque bande et non protégée par les zones subsistantes 61 de la deuxième couche isolante intermédiaire 56. Cette attaque permet de mettre à nu la couche semi-conductrice 32 entre les bandes 35. On dissous en même temps les remblais 58, 59.

On forme alors, par oxydation thermique de préférence, une couche mince d'oxyde de silicium 38 sur le silicium 32 du substrat et une couche similaire 39 sur un flanc latéral et sur le dessus des bandes du premier niveau de silicium polycristallin, mais pas sur l'autre flanc latéral car il est recouvert de nitrure de silicium qui ne s'oxyde pas. (figure 11A).

Enfin, on enlève le nitrure de silicium 61 avant de déposer le deuxième niveau de silicium polycristallin, comme cela a été expliqué précédemment.

Le procédé qui vient d'être décrit permet bien de localiser avec une grande précision les zones implantées de troisième type, dans un dispositif à transfert de charges présentant des électrodes de type mixte, à pas réduit. Il permet en outre de réaliser, grâce à un ensemble d'opérations communes, et sur le même substrat semi-conducteur, également un dispositif à transfert de charges plus classique présentant deux niveaux d'électrodes et pouvant fonctionner soit en deux phases, soit en quatre phases.

Le procédé selon l'invention est applicable non seulement à un registre à électrodes mixtes (c'est là qu'il trouve son plus grand intérêt en permettant la réalisation d'électrodes toutes identiques) mais aussi à des registres à deux phases et à des registres à trois ou quatre phases.

**Revendications**

1. Procédé de fabrication d'un registre à décalage à transfert de charges, comprenant la formation d'électrodes (53) au dessus d'une couche semiconductrice dopée (32), caractérisé en ce que les électrodes sont réalisées par des étapes de procédé identiques et simultanées pour toutes les électrodes d'un même pas du registre.

2. Procédé de fabrication selon la revendication 1, caractérisé en ce que les électrodes sont réalisées par une succession de plusieurs dépôts conducteurs (34, 40, 52) reliés électriquement les uns aux autres dans une même électrode après la fin du procédé.

3. Procédé de fabrication selon la revendication 2, caractérisé en ce qu'une zone (50) de couche semiconductrice dopée localement différemment est réalisée au dessous d'un bord de chaque électrode, cette zone étant réalisée après un dépôt conducteur (40) servant partiellement à la formation des électrodes et avant un autre dépôt conducteur (52) servant également partiellement à la formation des mêmes électrodes.

4. Procédé selon la revendication 2, caractérisé par les opérations successives suivantes :
- sur un substrat (31) comprenant une couche semiconductrice (32) recouverte d'une couche isolante (33), on dépose une première couche conductrice (34) et on la grave pour définir des bandes (35) séparées;
- on forme un isolant superficiel (38) au moins sur un flanc latéral de ces bandes;
- on dépose une deuxième couche conductrice (40) venant en contact avec une partie dénudée de chaque bande (35);
- on grave la deuxième couche de part et d'autre du flanc recouvert d'isolant en formant un espace vide étroit (46) entre deux bandes adjacentes, le flanc isolant établissant alors une isolation électrique entre bandes adjacentes;
- on dépose une troisième couche conductrice (52) fortement couvrante qui remplit l'espace étroit;
- et on grave la troisième couche sur une profondeur suffisante pour mettre à nu une portion de bande recouverte d'isolant (38) et ainsi séparer électriquement une portion de troisième couche au dessus d'une bande et une portion de troisième couche au dessus d'une bande adjacente.

5. Procédé selon la revendication 4, caractérisé en ce qu'un dopage (50), de préférence par implantation ionique, est fait dans l'intervalle étroit gravé après dépôt de la deuxième couche, intervalle qui sera rebouché par la troisième couche.

6. Registre à décalage à transfert de charges réalisé selon le procédé de l'une des revendications précédentes, comprenant, au dessus d'une couche semiconductrice dopée (32), une succession d'électrodes (53) servant chacune à la fois au transfert et au stockage de charges, caractérisé en ce que :
- toutes les électrodes sont identiques,
- et une zone (50) dopée localement différemment de la couche, autoalignée avec le bord de l'électrode, est réalisée sous toutes les électrodes du registre.

7. Procédé de fabrication d'un dispositif à transfert de charges selon l'une des revendications 1 à 5, consistant à utiliser un substrat semi-conducteur (31) de silicium dopé d'un premier type recouvert par une couche semi-conductrice (32) de silicium dopé d'un deuxième type, elle-même recouverte d'une première couche isolante principale (33), caractérisé en ce qu'il consiste ensuite :
- à former une première couche (34) de silicium polycristallin sur la première couche isolante principale (33), puis à découper des bandes (35) à flancs parallèles dans cette première couche de silicium polycristallin, en mettant à nu la couche semi-conductrice de deuxième type, entre ces bandes (35),
- former au moins une deuxième couche isolante principale (38 ou 39) entre lesdites bandes (35), à la surface de chaque bande et sur au moins l'un des flancs de chaque bande, puis à déposer une deuxième couche (40) de silicium polycristallin sur la deuxième couche isolante principale (38 ou 39),
- à découper la deuxième (40) couche de silicium polycristallin, par gravure à travers un masque, pour laisser subsister au moins un remblai (43 ou 44, 45) de la deuxième couche (40) de silicium polycristallin sur le flanc de chaque bande (35) recouvert de la deuxième couche isolante principale (38 ou 39), et pour creuser au moins une rainure (46 ou 48, 49) mettant à nu la deuxième couche isolante principale (38 ou 39) le long de chaque remblai (43 ou 44, 45) de la deuxième couche de silicium polycristallin et pour mettre à nu la deuxième couche isolante principale (38 ou 39) au moins partiellement à la surface de chaque bande (35),
- à effectuer une implantation ionique pour former des zones semi-conductrices (50) dopées de troisième type dans la couche semi-conductrice (32) dopée de deuxième type, respectivement en regard d'un ensemble de rainures (46),
- à former une troisième couche (52) de silicium polycristallin sur les parties subsistantes de la deuxième couche (40) de silicium polycristallin et sur les parties mises à nu de la deuxième couche isolante principale (38 ou 39), puis à effectuer une planarisation et une gravure de la troisième couche (52) de silicium polycristallin pour ne laisser subsister cette troisième couche de silicium polycristallin que dans lesdites rainures (46 ou 48, 49).

8. Procédé selon la revendication 7, caractérisé en ce que le découpage des bandes parallèles (35) dans la première couche (34) de silicium polycristallin, en mettant à nu la couche semi-conductrice (32) de deuxième type entre ces bandes, consiste :
- à découper lesdites bandes parallèles (35) par gravure sélective à travers un masque, de la première couche (34) de silicium polycristallin,
- à former sur ces bandes (35) et sur la première couche isolante principale (33) entre ces bandes, une première couche isolante intermédiaire (56) de nitrure de silicium recouverte par une deuxième couche isolante intermédiaire (57) d'oxyde de silicium,
- à effectuer une gravure anisotrope de la deuxième couche isolante intermédiaire (57) pour laisser subsister des remblais (58, 59) de la deuxième couche isolante intermédiaire, le long des flancs de chaque bande (35),
- à effectuer une attaque chimique à travers un masque, d'un remblai (58) de chaque bande, les remblais (59) subsistants à la suite de cette attaque étant situés d'une même côté de chaque bande (35),
- à effectuer une gravure de la deuxième couche isolante intermédiaire (56) et des remblais (59) subsistants pour ne laisser subsister que des zones (61) de cette deuxième couche intermédiaire, en regard des emplacements desdits remblais,
- à effectuer une attaque chimique de la première couche principale (33) d'isolant, non protégée par chaque bande (35) et non protégée par les zones subsistantes (61) de la première couche isolante intermédiaire.

9. Procédé selon la revendication 7, caractérisé en ce que le découpage des bandes parallèles (35) dans la première couche (34) de silicium polycristallin, en mettant à nu la couche semi-conductrice (32) de deuxième type entre ces bandes consiste :
- à découper lesdites bandes parallèles (35) par gravure sélective à travers un masque, de la première couche de silicium polycristallin (35),
- à former sur ces bandes (35) et sur la première couche isolante principale (33), entre ces bandes, une première couche isolante intermédiaire (56) de nitrure de silicium, recouverte par une deuxième couche isolante intermédiaire (57) d'oxyde de silicium,
- à effectuer une gravure anisotrope de la deuxième couche isolante intermédiaire (57), pour laisser subsister des remblais (58, 59) de la deuxième couche isolante intermédiaire, le long des flancs de chaque bande (35),
- à effectuer une attaque chimique des remblais (58, 59) et une gravure de la première couche isolante intermédiaire (56),
- à effectuer une attaque chimique de la première couche principale (33) d'isolante non protégée pour chaque bande (35).

# FIG. 1

# FIG. 2

# FIG. 3

FIG. 4 a

FIG. 4 b

FIG. 5 a

FIG. 5 b

FIG. 6 a

FIG. 6 b

FIG. 7 a

FIG. 7 b

## FIG. 8 a

Si₃N₄   SiO₂   35   58   56   59

33   32   31   N   P

## FIG. 8 b

35   58   59

N   P

## FIG. 9 a

35   59   60

N   P

## FIG. 9 b

35   56

N   P

## FIG. 10 a

Si₃N₄   35   61   36

33   32   31   N   P

## FIG. 10 b

35   37

33   32   31   N   P

## FIG. 11 a

SiO₂   61   35   38   39   Si₃N₄

33   32   SiO₂   N   P

## FIG. 11 b

35   39

33   32

EP 0 376 777 A1

FIG. 12 a

FIG. 12 b

FIG. 13 a

FIG. 13 b

FIG. 14 a

FIG. 14 b

FIG. 15 a

FIG. 15 b

# RAPPORT DE RECHERCHE EUROPEENNE

Numero de la demande

EP  89 40 3364

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| X | FR-A-2 569 486  (VEB WERK FÜR FERNSEHELEKTRONIK) <br> * Résumé; page 9, ligne 10 - page 10, ligne 31; figures 1a,1b * | 1,3,5,6 , | H 01 L  21/82 <br> H 01 L  29/60 <br> H 01 L  29/796 |
| A | | 2,4 | |
| D,A | EP-A-0 207 328  (EASTMAN KODAK CO.) <br> * Revendications 1-12 * <br> --- | 7-9 | |
| A | FR-A-2 286 506  (N.V. PHILIP'S GLOEILAMPENFABRIEKEN) <br> --- | 7-9 | |
| A | US-A-4 077 112  (M.J.J. THEUNISSEN et al.) <br> --- | | |
| A | EP-A-0 220 989  (THOMSON-CSF) <br> --- | | |
| A | US-A-4 148 132  (R.W. BOWER) <br> ----- | | |

**DOMAINES TECHNIQUES RECHERCHES (Int. Cl.5)**

H 01 L

**Le présent rapport a été établi pour toutes les revendications**

| Lieu de la recherche | Date d'achèvement de la recherche | Examinateur |
|---|---|---|
| LA HAYE | 23-01-1990 | ZOLLFRANK G.O. |